# EUROPEAN PATENT APPLICATION

(11) **EP 1 753 122 A1**
(43) Date of publication of application: **14.02.2007**
(21) Application number: 05076866.2
(22) Date of filing: 12.08.2005
(51) Int. Cl.: H02N 2/12, H01J 37/20

(54) **Movement platform for carrier with five degrees of freedom**

(71) Applicant: Nederlandse Organisatie voor toegepast-natuurwetenschappelijk Onderzoek TNO, 2628 VK Delft (NL)
(72) Inventor: Klinkhamer, Jacob Frederik Friso, 2611 GD Delft (NL)
(74) Representative: Winckels, Johannes Hubertus F.

(57) **Abstract**

A movement platform provided with a carrier (2) and at least as three spaced apart clamping means (3), wherein the clamping means each clamp the carrier at a contact point (13) at at least one globular contact surface (14) of the carrier, while at least one clamping means is provided with at least one displacement (4) element for displacing the contact point relative to at least the respective contact surface and/or at least the respective clamping means such that the carrier can rotate about at least two imaginary axes, while the normal forces (Fn) applied by the clamping means to the carrier are in approximately parallel planes, which parallel planes are approximately perpendicular to the tangential plane at the globular surface at the respective contact point.

## Description

The invention relates to a movement platform for rotating a carrier.

Known movement platforms for rotating a carrier about at least two axes, such as known from, for instance, EP 1 111 692, utilize three or four supporting means and a spherical carrier. Here, the carrier rests on the supporting means through gravity, so that for many uses, such a system is insufficiently stable, in particular when the carrier is very light. With small external vibrations, the spherical carrier can easily move.

It is known from, for instance, US 5 872 417 to utilize movement platforms where the carrier is supported at the underside by supporting means while at the top side, compression means press against the supporting means. With this known form, only a small surface is left clear between the supporting and compression means, so that this known form is not particularly suited to allow the passage of an electromagnetic beam.

One object of the invention is to enable highly accurate rotation and displacement of the carrier. Preferably, this is possible with an accuracy of less than 1 nanometer.

Another object of the invention is to allow movement, rotation and/or removal of the carrier within a very compact area.

At least a number of these and other objects are achieved with a movement platform provided with a carrier and at least three spaced apart clamping means, wherein the clamping means each clamp the carrier at a contact point at at least one globular contact surface of the carrier, while at least two clamping means are each provided with at least one displacement element for displacing at least one contact point relative to said contact surface and/or at least one clamping means such that the carrier can rotate about at least two imaginary axes. Here, the normal forces applied by the clamping means to the carrier are in approximately parallel planes, which parallel planes are approximately perpendicular to the tangential plane at the globular contact surface at the respective contact point.

A movement platform according to the invention is suitable for, for instance, microscopy, in particular transmission electron microscopy, optics, lithography, robotics, micro assemblage et cetera. A carrier is, for instance, a stage, a holder or the like, in which for instance a specimen can be placed. The carrier can also be suitable for carrying a camera, lens, chip, sensor, mirror or the like, depending on the use of the movement platform.

Clamping means clamp the carrier approximately perpendicularly, that is to say, radially, to the contact surface which is globular at the location of a contact point. Contact surface is understood to include the surface of the carrier on which the clamping means engage. Here, the contact point is the point where the clamping means clamps the carrier. With a globular design of the carrier, it can relatively easily be rotated between clamping means.

For a proper understanding of the invention, a distinction is made in this description between globular and spherical. Herein, globular is understood to include convex, spherical or, for instance, bent in double curves, however also hollow or concave. Globular therefore includes a ball, round cone, torus-shape, in principle doubly curved surfaces which are at least partly elliptical or circular in three orthogonal directions. In this description, globular should be construed to have a meaning broader than spherical, while spherical is to be understood as having the shape of a completely round cone, or being entirely round in all orthogonal views, at least in as far as this concerns the at least one contact surface. Here, the (contact) surface of a torus is indeed globular but not spherical.

In an advantageous embodiment, a movement platform according to the invention can be designed to be very "flat". Here, the clamping means for instance are positioned so as to be substantially permanent in one plane, so that a movement platform can advantageously be designed to be very compact. Here, the normal forces are in one plane and the normal forces intersect approximately in the center of the clamping means and/or the carrier in the plane, also with rotations of the carrier. Also, embodiments are possible where the clamping means are substantially in one plane only in one middle position, that is, a position in which the carrier is not rotated. However, for rotation of the carrier, at least one clamping means and at least one normal force move out of this plane.

In the movement platform according to the invention, the normal forces applied by the clamping means, by clamping the carrier, are approximately perpendicular to the tangential plane of the globular contact surface through the respective contact point.

Clamping means can have the form of, for instance, arms, needles, plates, rods, faces, cubes, et cetera. For use within a microscope, it is advantageous when the specimen can be rotated about at least two axes, perpendicular to each other and perpendicular to the main direction of the electromagnetic beam. The main direction of the electromagnetic beam is understood to mean the main direction of, for instance, the photons or electrons radiating through or along the specimen.

In addition to rotations, the invention is also suitable for translations, in particular along three axes. This is very favorable for, for instance, examination of the specimen in applications such as microscopy.

In a preferred embodiment, the invention has three clamping means, so that translation is possible along three axes, at right angles relative to each other, and rotation is possible about at least two axes at right angles relative to each other. More than three clamping means render the movement platform, in principle, overconstrained. A minimum of clamping means can for instance be desirable as the clamping means will then undergo less slip, which may be caused by imperfectly coordinated movements of the clamping means relative to each other upon a translation or rotation of the carrier.

For rotation and/or translation of the carrier, displacement elements are provided. They displace clamping means at least tangentially and radially (perpendicularly) relative to the globular contact surface at the respective contact point. Displacement elements comprise, for instance, pistons or piezo-elements, with which, in a movement platform according to the invention, a contact point can be displaced by a user with the aid of clamping means, with an accuracy of less than approximately 1 nanometer.

Another advantage of the invention is that the carrier can rotate, move and/or be held in position with great stability. This means, for instance, that the carrier vibrates relatively little, for instance due to influences from outside and/or irregularities in the displacement elements because of, for instance, noise in electric voltage. The stability is characterized in that, for instance, vibrations can be achieved of less than approximately 0.1 nanometer.

In a preferred embodiment according to the invention, the carrier comprises a recess. This serves as "inspection hole" in which or through which for instance a specimen is borne/held and can be examined. A recess could also be designed for including a lens, camera, chip, sensor, mirror or the like. With microscopes, for instance, it is advantageous when the recess is continuous, so that a beam of electromagnetic radiation (photons, electrons, ultraviolet radiation et cetera) falls through the recess on a projection surface (and through and along, for instance, a specimen). Thus, an image is created. In an advantageous manner, with the aid of a double conical shape, that is, an hourglass shape, the beam can proceed straight through the recess if the carrier is rotated from a middle position. For a maximum angular rotation of the carrier, the clamping means are, in a middle position, at approximately an equal distance from the recess.

In an advantageous embodiment, at least one clamping means is provided with resilient and/or hinging elements, with which overconstraint of the movement platform is removed as much as possible. In a preferred embodiment, one clamping means is provided with resilient and hinging elements and a second clamping means with hinging elements. Herewith, resistance the clamping elements may produce relative to each other, for instance in the case of not properly coordinated movements of the clamping means relative to each other, can be advantageously reduced. In addition, slip between clamping means and carrier is prevented. In general, due to these features, the stability and accuracy of the movement platform are further increased.

In a preferred embodiment, piezo elements are used as displacement elements. This technique is advantageous for a device according to the invention because it is, inter alia, energy-friendly, robust, it comprises no moving parts and is very precise.

An advantageous embodiment of the invention utilizes one or more linear piezomotors. This is a principle known to the skilled person, known for instance from "Constructieprincipes voor het nauwkeurig bewegen en positioneren" (Constructional principles for accurate movement and positioning) by M.P. Koster, 1996, published by University of Twente of Enschede, the Netherlands, which principles will only be described here insofar as relevant to a proper understanding of the invention. Other principles too, such as, for instance, an Impact Drive Motor, a travelling wave motor, a Sliding Friction Motor or other (piezo) motors are eminently usable in a device according to the invention. However, the linear piezo motor has appeared highly advantageous as component of an embodiment of the invention. Here, one clamping means preferably comprises two fingers, which, very closely together, engage the carrier. The two points of contact of these fingers with the carrier can therefore be considered as one contact point. Here, the contact point is approximately in the middle of the two points of contact. At that contact point, the two fingers are approximately perpendicular to the carrier. For rotating the carrier, the two fingers "walk" in place. "Walk" is at least understood to include that a first finger clamps and rotates the carrier while the other one allows the carrier to pass, for instance through release from the contact surface, or letting it slip. If the carrier is to be rotated further, a second finger of the same clamping means takes it over and rotates the carrier while the first finger "retracts" and moves along the second finger in the opposite direction. Hereafter, the first finger can take over again and rotate the carrier, with the second finger retracting and moving along the first finger in opposite direction. In principle, this cycle keeps repeating itself until the desired end position is achieved.

An advantage of such an embodiment is that the movement platform can be designed very compactly. The fact is that upon rotation, the carrier rotates approximately about its own axis while the compactly designable fingers also remain approximately in place. During use, the fingers can remain in one plane, so that the movement platform can be of very flat design. As a result of this too, a preferably substantially spherical carrier with, for instance, continuous recess can rotate through great angles.

In an advantageous embodiment, use is made of a "lame" walker whereby, with the aid of displacement means, from one clamping means only one finger is displaced and the other one is passive. "Passive" is understood to mean not provided with displacement elements. The advantage hereof is that in a condition of rest, the carrier can be clamped by the passive finger and that thus, a stable situation is achieved due to little influence of noise and/or vibrations in and from the displacement element.

A movement platform according to the invention is very suitable as movement platform for a microscope, in particular a transmission electron microscope. In order to examine the specimen within the very compact space in the microscope between pole shoes of a transmission electron microscope with very high stability, in a preferred embodiment, the clamping means are preferably attached to the lower pole shoe. By attaching the clamping means to the lower pole shoe, the carrier can be included in the clamping means in a relatively simple manner.

The invention also relates to a specimen carrier, which is eminently suitable to be taken up in a movement platform according to the invention.

In clarification of the invention, embodiments of the devices and a method according to the invention will be further elucidated with reference to the drawing. In the drawing:
Fig. 1 schematically shows, in top plan view, a movement platform according to an embodiment of the invention;
Fig. 2 schematically shows, in front view, a cross section A-A of a movement platform according to Fig. 1 in a middle position;
Fig. 3 schematically shows, in front view, a cross section of a movement platform as shown in Fig. 2, in rotated position;
Fig. 4 schematically shows, in front view, a cross-section of a movement platform in a second embodiment of the invention in rotated position;
Fig. 5 schematically shows, in front view, a finger with piezo elements against a contact surface according to the embodiment of the invention;
Fig. 5A schematically shows, in front view, a finger with piezo elements against a concave contact surface according to an embodiment of the invention;
Fig. 6 schematically shows, in perspective view, a movement platform according to an advantageous embodiment of the invention;
Fig. 7 schematically shows, in front view, a cross-section of a movement platform in a transmission electron microscope; and
Fig. 8 schematically shows, in top plan view, a clamping means with one lame finger.

In this description, identical or corresponding parts have identical or corresponding reference numerals. As exemplary embodiment is described, inter alia, a movement platform for a transmission electron microscope. However, the invention is suitable for several uses where a carrier is rotated. For instance, a movement platform according to the invention can be used in optics, in the field of technology of micro assemblage, with different types of microscopy, with robots, in particular micro or nano robots, in lithography, cameras, sensors et cetera.

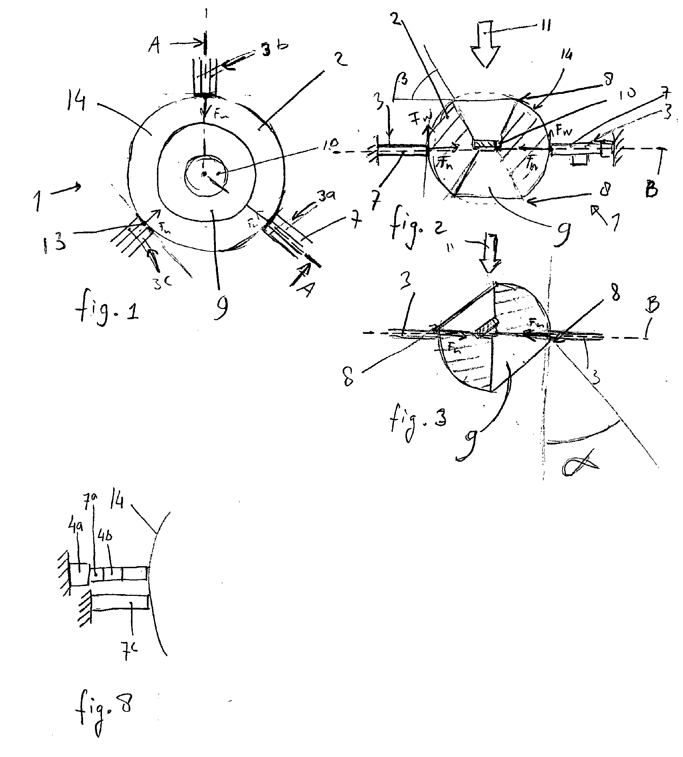

An embodiment according to the invention, as shown in, for instance, Figs. 1-3, comprises a movement platform 1 in which a specimen 10 can be placed. The specimen 10 comprises, for instance, a sample, material, bacteria or the like which is to be magnified for, for instance, further examination. In, for instance, an electron microscope, a part of the composition of the specimen 10 can be magnified accurate to, or below the nanometer, so that for instance the composition of atoms and/or molecules of the specimen 10 becomes visible to the user. Here, it is advantageous when the specimen 10 can be set in several positions relative to the microscope, in particular the electron beam, for instance such that particular parts of (molecules of) the specimen 10 appear in view more favourably. To this end, the invention provides a movement platform 1 where the specimen 10 is borne by a carrier 2 as shown in, for instance, in Figs. 1-3, while Fig. 2 is a cross-section A-A- of Fig. 1.

The spherical carrier 2 shown in Figs. 1, 2, 3, 6 and 7 is included in a movement platform 1 between three clamping means 3. The clamping means 3 hold the carrier in the correct position by applying a normal force Fn, indicated by Fn, perpendicularly to a spherical contact surface 14. In this manner, frictional force Fw, indicated with Fw, is produced for clamping the carrier 2. With at least three clamping means 3, the specimen 10 can be favourably translated and rotated along and about three mutually perpendicular axes.

In Fig. 4, the carrier 2 has a globular contact surface 14. In this description, the contact surface 14 is the surface where the carrier 2 can be engaged by clamping means 3. In Fig. 4, clamping means 3 are designed as plates which move along the contact surface 14. It can be seen here that the carrier 2 will rotate when at least one clamping means 3 moves relative to the globular contact surface 14, for instance in a direction indicated with arrows 20.

In another advantageous embodiment, clamping means 3 are designed as "walking fingers" 7, as is the case in Figs. 1-3 and 5-7. Here, a clamping means 3 comprises, in principle, at least two fingers 7 which walk with the ends over the contact surface 14 of the carrier 2, while the carrier 2 rotates and the center of the carrier 2 remains approximately in place. This can for instance be effected by having a pair of fingers 7 "walk" in the opposite direction with respect to an opposite pair of fingers 7. The skilled person will understand that the walking speeds can be coupled algorithmically with respect to each other, for instance in the case of an uneven number of clamping means 3.

Both the plate-shaped and the finger-shaped clamping means 3 engage the carrier 2 at contact points 13. Upon rotations of the carrier 2, the contact surface 14 "rolls" over the clamping means 3, or at least one finger 7 thereof. If the end of a clamping means 3 and/or finger 7 which is to engage the contact surface 14 is, for instance, flat or elongated, a contact point 13 is displaced both along the contact surface 14 and along the clamping means 3 upon rotation of the carrier 2. For a proper understanding of the invention, with embodiments according to the invention having fingers 7, each pair of fingers 7 can be considered as one clamping means 3, and the respective contact point 13 lies between the points of contact of the finger 7 with the carrier 2. In a minimal case, only one contact point 13 will move relative to one contact surface 14 or one clamping means 3. This latter may be the case with a movement platform 1 with at least two clamping means 3 having, for instance, pointed fingers 7. It will be clear to the skilled person that several embodiments of the clamping means 3 are possible according to the invention, within the framework of the invention, also the clamping means 3 of one embodiment can mutually differ.

An advantage of a substantially spherical carrier 2 is that the continuations of the normal force vectors Fn intersect approximately in this center and the contact points 13 remain approximately in one plane B both in a middle position and after rotation of the carrier 2. Therefore, all frictional forces Fw remain substantially the same in magnitude and direction, and a relatively stable and highly compact movement platform 1 is obtained. Hence, the movement platform 1 can be designed to be very flat.

It will, for that matter, be clear to the skilled person that the schematic representations of the Figures shown merely serve as explanation. For the sake of simplification, in the cross-sections, each time, only two clamping means 3 are represented. However, in practice, movement platforms 1 according to the invention will preferably comprise at least three clamping means 3. The skilled person will have no difficulty in making this adjustment.

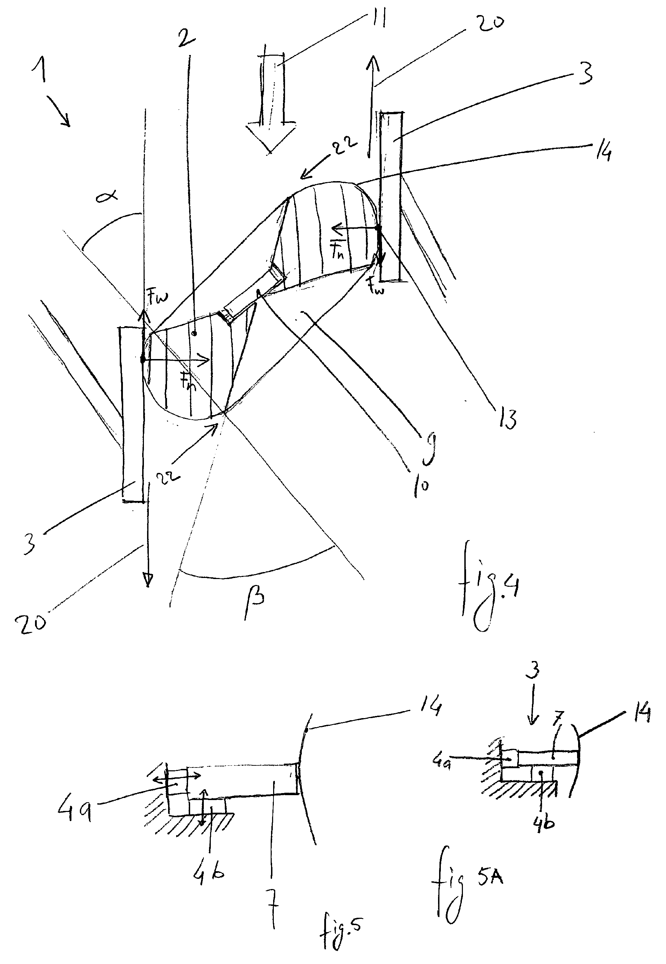

However, there are embodiments within the framework of the invention which (schematically) may indeed exhibit cross-sections as shown in Figs. 2 and 3. It is for instance possible to position along one axis through the center of carrier 2, which axis is preferably perpendicular to the main direction 11, at least two fingers 7 on each of two opposite sides of a carrier 2. The carrier 2 can then also be rotated about two axes perpendicular to the main direction 11 while primarily, less than three clamping means 3 seem to have been used. With such movement platforms 1, the single fingers 7 can also be considered as clamping means 3. It will be clear to the skilled person that this embodiment also falls within the framework of the invention.

To have the fingers 7 move, displacement elements are provided which can move a finger 7. In a preferred embodiment according to the invention, these are provided in the form of piezo elements 4. However, the invention is not limited thereto, many types of displacement elements are possible, for instance pistons, pivot motors and the like. Piezo elements 4 offer the advantage that they can transmit very small movements in a controllable manner. As can be seen in Fig. 5, with the aid of a piezo element 4a, a finger 7 is moved towards and from the carrier 2 in radial direction, that is, perpendicularly to the carrier 2, and, with the aid of a piezo element 4b, in tangential direction relative to the carrier 2.

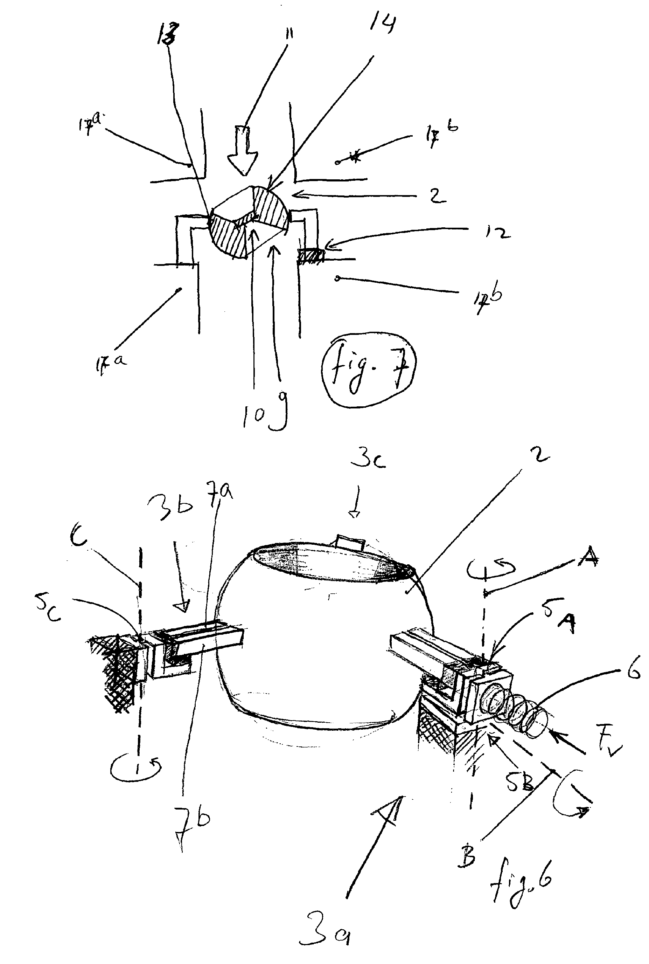

According to the walking principle, a movement of a finger 7 in radial direction by means of the piezo element 4a will at least contribute to a translation of the carrier 2, while a movement of a finger 7 in tangential direction, by means of piezo element 4b, will contribute to rotation of the carrier 2. In Fig. 6, an embodiment is shown with clamping means 3 comprising two fingers 7a, 7b. Per clamping means 3, the carrier will each time be clamped by at least one finger 7 of a pair 7a, 7b. By moving the first finger 7a in tangential direction, while another finger 7b is retracted in radial direction, the carrier 2 will rotate. Hereafter, the first finger 7a is retracted in radial direction, taking along the carrier 2 (on the opposite side of the carrier 2, also a force in radial direction is applied) until the other finger 7b takes over the carrier 2. Hereupon, the other finger 7b will move in tangential direction so that the carrier 2 rotates further. This other finger 7b will then, again, retract in radial direction so that the first finger 7a, in a clamping position, "takes over" the carrier 2 again and the cycle starts anew. Thus, in an advantageous manner, the carrier 2 can be rotated relatively stably and smoothly. Naturally, the walking principle can also be applied in different manners, through different control of the displacement elements.

In general, displacement elements can be susceptible to vibrations or uncontrolled variations. It is for instance difficult to prevent piezo elements 4 from experiencing voltage noise which will cause vibrations in the piezo elements 4. It may therefore be favorable to use as few displacement elements as possible. Considering the above, according to a preferred embodiment according to the invention, per clamping means 3, one "lame" finger 7c can be advantageously used, as shown in Fig. 8. Here, per clamping means 3, one first finger 7a will be displaced radially as well as tangentially relative to the carrier 2 by means of displacement elements, while a second finger 7c remains stable. This second finger 7c serves as "resting point". In this manner, in particular when the carrier 2 is being held in position, a highly stable movement platform 1 is achieved as the vibrations are reduced or isolated.

Naturally, many other "walking" principles are conceivable within the framework of the invention. Also, many displacement means are known that can be used with a movement platform 1 according to the invention, such as for instance an Impact Drive Motor, a travelling wave motor, a Sliding Friction Motor et cetera. These examples of displacement elements relate to piezo elements 4. With other displacement elements, also a wide range of possibilities will present itself. These are also understood to fall within the framework of the invention.

When utilizing an embodiment according to the invention in an electron microscope, carrier 2 can be provided with a recess 9. The recess 9 enables the electron beam to fall in a main direction 11 through the carrier 2. Due to the presence of the specimen 10, the beam will be interrupted in the recess 9, or, at the issuing side of the carrier 2, the intensity of the beam will differ across the cross-section perpendicular to the main direction 11 (the projection). Through a subsequent capturing and processing of this difference in intensity, an image of the specimen 10 with a very high resolution can be obtained. It will be clear that the recess 9 can also be advantageous for other forms of electro magnetic radiation, for instance a light beam, ultraviolet radiation et cetera.

The carrier 2 must also allow the passage of the electro magnetic radiation with rotations in the main direction 11. As represented in Figs. 2 - 4, to this end, the recess 9 can have the form of a double cone or hourglass, so that a part of the electron beam will fall in the main direction 11 through the recess up to relatively great angles of rotation. Here, α is the angle the carrier 2 has made from a middle position about a corresponding axis. In a middle position the angle of rotation α, is therefore 0°.

If a carrier 2 according to the invention is substantially spherical, as is the case in Figs. 1- 3 or 5 - 7, it can, in principle, rotate through 360° in all directions. In a preferred embodiment, the spherical form 2 is truncated at the recess 9 so that rotation is only possible until the clamping means 3 clamp the spherical carrier 3 approximately at the location of the truncation 8. Here, it is favorable to provide the recess 9 with an angle of inclination β of approximately 45°. As can be seen in Fig. 3, at an angle of rotation of approximately 45°, a part of the electron beam with main direction 11 can still fall straight through the recess 9 at an angle of inclination β of approximately 45°. If further rotation were to take place, the clamping means 3 will engage the recess 9 and, furthermore, the electrons will be blocked in the main direction 11. With a smaller angle of inclination β of the recess 9, the electron beam will already be blocked in the main direction 11 at a smaller angle of rotation α.

In order to, nevertheless, reach greater angles of rotation, in a different embodiment according to the invention, the carrier 2 can be of torus-shaped design, as shown in, for instance, Fig. 4. The torus-shaped carrier 2 needs not be truncated as the recess 9 runs through a center part 22 of the torus-shape so that the angle of rotation α is not bound by truncations. The angle of rotation α with which an electron beam in the main direction 11 is still allowed to pass through a recess 9, may increase here to, for instance, approximately 70°. The magnitude of the maximum angle of rotation α depends, inter alia, on the coefficient of friction of the torus-shaped carrier 2 and the clamping means 3. It also depends, amongst others, on the angle of inclination β of the torus-shaped carrier 2. For a maximum angle of rotation α of approximately 70°, a minimum angle of inclination β is required of at least approximately 70° for allowing at least a part of the electron beam to pass in the main direction 11 through the recess 9. With this, thus, a carrier 2 according to the invention is provided with which, in a highly advantageous manner, great angles of rotation α are effected.

With an embodiment according to the invention with torus-shaped carrier 2, as shown in, for instance, Fig. 4, it is advantageous to use plate-shaped clamping means 3. These clamping means 3 clamp the torus-shaped carrier, at a contact point 13, perpendicular to the contact surface (tangent plane) at the globular contact surface 14. Upon rotation, the torus-shaped carrier 2 will inevitably be tilted so that here, the contact points 13 of the plate-shaped clamping means 3 are not in one plane B.

It is self-evident that the plate-shaped clamping means 3 are also suitable for clamping the spherical carrier 2, while the contact points 13 are indeed approximately in one plane B and the normal forces Fn do intersect in the middle of the carrier 2.

If the clamping means 3 are not controlled exactly synchronously upon rotation of the carrier 2, slip may occur, which may lead to inaccuracies. In this manner, in particular an overconstrained system 1 may lead to inaccuracies. To avoid this, in a preferred embodiment of a movement platform 1 according to the invention, at least one clamping means 3a is arranged in a hinging and resilient manner.

Such an embodiment according to the invention is shown in Fig. 6. It comprises three clamping means 3a, 3b, and 3c, the last of which (3c) being arranged behind the carrier 2, viewed in the plane of the Figure. A preferred embodiment according to the invention utilizes at least one clamping means 3a hingedly disposed about an axis A by means of a hinge element 6a. In this manner, formation of slip in the hinging direction, that is, the corresponding tangential direction is largely prevented. The clamping means 3a too is hingedly disposed about a second axis B by means of a second hinge element 5B so that formation of slip in a corresponding, second tangential direction, that is, the respective hinging direction is largely prevented. Here, axis A and axis B are approximately perpendicular to each other. By means of a hinge element 6c, another clamping means 3b hinges about axis C, which axis is parallel to axis A. Hence, slip of the clamping means 3b in a corresponding, tangential direction is largely prevented. A third clamping means 3c is disposed in a rigid manner.

Another overconstraint can be removed by providing clamping means 3a with a resilient or compression element 6. The clamping means 3a with the resilient element gives way in the spring direction, while this clamping means 3a with resilient element 6 still applies sufficient clamping force Fn to the carrier 2. Using a resilient element 6, for instance a spring, a piston, an elastic element, et cetera, with a clamping means 3 removes resistance with translations in the spring direction, preferably approximately perpendicularly to the respective clamping means 3a. By removing the resistance, in an advantageous manner, slip will again be prevented to a large extent.

It will be clear to the skilled person that such hinging and resilient elements 5, 6 can also be used on other embodiments according to the invention, for instance with plate-shaped clamping means 3.

The movement platform 1 according to the invention enables rotation and translation about and along at least three axes in a highly advantageous manner. In applications for, for instance, electron microscopes, rotation about two mutually perpendicular axes is often sufficient, which axes are perpendicular to the main direction 11. Rotation perpendicular to a main direction 11 needs not be absolutely necessary because, to this end, other solutions may be available, such as, for instance, rotation of a projection image by means of software. Here, the projection image is the depiction of the specimen 10 obtained afterwards on, for instance, a computer. Here, it is favorable to use at least two hinging clamping means 3, with the aid of, for instance, the hinges 5A-C mentioned.

With the embodiment where the carrier 2 rotates only about the two axes perpendicular to the main direction 11, unintentional rotations of the carrier 2 about the main direction 11 can be formed as a result of specific orders of rotations about the two axes perpendicular to the main direction 11. Such unintentional rotations can be prevented by taking these into account in the algorithmics coordinating the rotations about the other two axes. An unintentional rotation about the main direction 11 can also be cancelled through a different control of the rotations about the other two axes.

With a transmission electron microscope, an embodiment of a movement platform 1 according to the invention is placed nearby the pole shoes 17 so that the electron beam falls stably along and/or through the carrier 2. Between the pole shoes 17a and 17b, the electron beam radiates in main direction 11. Between the upper and lower pole shoes 17 (as indicated in Fig. 6), a compact space is left clear for placing the sample 10. Here, it is advantageous when the clamping means 3 are attached to the lower pole shoe 17a2 and 17b2 so that the carrier 2 can be placed between the clamping means 3 in a relatively simple manner. In most transmission electron microscopes, this space has a length, width and height of approximately a few millimeters. Embodiments according to the invention can be advantageously used within this compact space.

In Fig. 7, it is schematically represented that the clamping means 3 are attached in an advantageous manner to the pole shoes 17 of a transmission electron microscope. It is also favorable if a carrier 2 can be taken from and placed in a microscope in a simple manner so that the specimen 10 can be provided in a simple manner. To this end, at least one of the clamping means 3 can be loosened from and re-attached to the microscope via, for instance, at least one attachment means 12, so that the carrier 2 can be taken therefrom in a simple manner for placing a specimen 10 into and/or taking a specimen 10 out of the microscope. It is advantageous if this clamping means 3 is the clamping means 3a with which both resilient and hinging elements 5, 6 are provided, so that, in an advantageous manner, replacing the clamping means 31 has little influence on the accuracy of the system. It is advantageous if the clamping means 3 are then attached to the lower pole shoe 17a2 and 17b2 so that a clamping means 3, preferably the clamping means 3a, can be attached relatively easily.

Naturally, also the entire movement platform 1 can be removable from the microscope or, conversely, be fixedly provided. Also, separate parts of the movement platform 1, such as for instance the carrier 2 can be replaced within the framework of the invention.

It will be clear that several embodiments fall within the framework of the invention. It is for instance possible that a specimen 10 is positioned on or in the carrier 2 via another part, for instance a holder, or that the movement platform 1 is placed in a holder. Many intermediate parts are conceivable which may imply a modification but with which the inventive concept remains intact. Furthermore, the movement platform 1 can be placed at any angle relative to, for instance, a microscope or the earth. In a middle position, the movement platform 1 can for instance be askew, vertical, horizontal, et cetera. The carrier 2 may also stand still and the movement platform 1 may move, et cetera. As is represented in, for instance, Fig. 5A, the contact surface 14 can be designed to be hollow or concave while the clamping means 3 are for instance provided on the inside of the carrier 2. Also, the clamping means 3 can adopt many shapes. Many embodiments according to the invention which have not been mentioned in this document will be clear to the skilled person.

## Claims

1. A movement platform provided with a carrier and at least three spaced apart clamping means, wherein the clamping means each clamp the carrier at a contact point at at least one globular contact surface of the carrier, while at least one clamping means is provided with at least one displacement element for displacing the contact point relative to at least the respective contact surface and/or at least the respective clamping means such that the carrier can rotate about at least two imaginary axes, while the normal forces applied by the clamping means to the carrier are in approximately parallel planes, which parallel planes are approximately perpendicular to the tangential plane at the globular surface at the respective contact point.

2. A movement platform according to claim 1, wherein the displacements element are designed to displace the at least one clamping means in at least one direction approximately perpendicular to the carrier at a contact point and/or approximately tangential relative to the carrier at a contact point.

3. A movement platform according to claim 1 or 2, wherein the carrier has a substantially spherical form which is truncated, preferably at two opposite sides.

4. A movement platform according to any one of claims 1 or 2, wherein the carrier is substantially torus-shaped.

5. A movement platform according to anyone of the preceding claims, wherein in the carrier, at least one recess is provided

6. A movement platform according to claim 5, wherein the recess is a continuous recess.

7. A movement platform according to claim 6, wherein in a middle position, the distance from the clamping means to a first edge of the recess and to a second edge of the recess located at the opposite side of the carrier is approximately equal.

8. A movement platform according to anyone of the preceding claims, wherein the normal forces applied by the clamping means to the carrier are approximately in one plane and in a direction approximately through the center of the carrier.

9. A movement platform according to anyone of preceding claims, wherein at least one clamping means comprises a resilient element which applies a force perpendicular to the tangential plane at the respective contact point.

10. A movement platform according to anyone of preceding claims, wherein at least one clamping means, preferably two clamping means, comprises at least one hinging element.

11. A movement platform according to claim 9 or 10, wherein a clamping means is provided with at least one resilient and at least one hinging element.

12. A movement platform according to anyone of the preceding claims, wherein the clamping means clamp the carrier by means of plates.

13. A movement platform according to anyone of the preceding claims, wherein the clamping means each comprise two fingers.

14. A movement platform according to claim 13, wherein per clamping means only one finger is provided of at least one displacement element for displacing a contact surface, contact line or end of the finger approximately tangentially relative to the carrier at the respective contact point and/or of a displacement element for displacing the contact surface, the contact line or the end of the finger approximately perpendicularly relative to the carrier at the respective contact point.

15. A movement platform according to any one of the preceding claims, wherein for the purpose of taking out the carrier, at least one part of at least one clamping means is removable.

16. A movement platform according to any one of the preceding claims, wherein at least a part of at least one clamping means with at least one hinging element and/or one resilient element is removable.

17. A movement platform according to any one of the preceding claims, wherein the displacement elements comprise piezo elements.

18. A movement platform according to any one of the preceding claims for rotating and positioning a specimen in a microscope, in particular an electron microscope, more particularly a transmission electron microscope.

19. A specimen carrier for a movement platform according to any one of the preceding claims, which specimen carrier comprises, substantially, a globular form, in particular a spherical form or torus-form, which is truncated at two opposite sides, while at least one recess is provided in a truncated plane.

20. A microscope with movement platform according to any one of claims 1 - 18.

21. A microscope according to claim 20, wherein the clamping means are attached at one end to the microscope.

22. A microscope according to any one of claims 20 or 21, wherein the microscope is a transmission electron microscope while the clamping means are attached to at least one pole shoe.

23. A method for rotating a carrier, wherein at least three clamping means each clamp a carrier at a contact point at at least one globular contact surface of the carrier, while at least one clamping means displaces the respective contact point relative to at least the respective contact surface and/or at least the respective clamping means, while the normal forces which are applied by the clamping means to the carrier are in approximately parallel planes, which parallel planes are approximately perpendicular to the tangential plane at the globular contact surface at the respective contact point.

24. A method according to claim 23, which method is used when rotating a specimen in a microscope, in particular a transmission electron microscope.
